# EUROPÄISCHE PATENTANMELDUNG

(11) **EP 0 684 020 A2**
(43) Veröffentlichungstag der Anmeldung: **29.11.1995**
(21) Anmeldenummer: 95100947.1
(22) Anmeldetag: 25.01.1995
(51) Int. Cl.: A61C 17/22, B24B 3/00, H05K 5/02

(54) **Gehäusewand eines Gehäuses für ein Gerät des persönlichen Bedarfs**

(30) Priorität: 23.02.1994 DE 4405764
(71) Anmelder: Braun Aktiengesellschaft, Frankfurt am Main (DE)
(72) Erfinder: Herzog, Karl, D-60489 Frankfurt (DE); Schwarz-Hartmann, Armin, D-55234 Albig (DE); Kressner, Gerhard, D-63674 Altenstadt (DE)

(57) **Zusammenfassung**

Es wird eine Wand (10), insbesondere Gehäusewand eines Gehäuses (12) für ein Gerät des persönlichen Bedarfs, z. B. Zahnbürste, Munddusche, Rasierapparat, Küchengerät oder dergleichen, beschrieben, bestehend aus einem ersten Kunststoff (14), mit einer Außenfläche (16) und einer Innenfläche (18) und mit wenigstens zwei mit einem zweiten Kunststoff (20) anderer Eigenschaften versehenen Bereichen der Außenfläche (16) der Wand (10). In diesen Bereichen (22, 24) ist jeweils wenigstens eine, den ersten Kunststoff (14) durchsetzende Durchbrechung (26, 28) der Wand (10) vorhanden. Zwischen den Durchbrechungen (26, 28) sind Verbindungsbereiche (30) auf der Innenfläche (18) der Wand ebenfalls mit dem zweiten Kunststoff (20) versehen. Der zweite Kunststoff (20) ist in den Bereichen (22, 24) und Verbindungsbereichen (30) einstückig zusammenhängend ausgebildet.

## Beschreibung

Die Erfindung betrifft eine Wand, insbesondere Gehäusewand eines Gehäuses für ein Gerät des persönlichen Bedarfs, wie Zahnbürste, Munddusche, Rasierapparat, Küchengerät oder -maschine und dergleichen, bestehend aus einem ersten Kunststoff oder dergleichen, mit einer Außenfläche und einer Innenfläche und mit wenigstens zwei mit einem zweiten Kunststoff anderer Eigenschaften, z. B. Farbe, Härte, Reibwert oder dergleichen, versehenen Bereichen der Außen- und/oder Innenfläche der Wand.

Derartige Wände sind bereits bekannt und werden insbesondere als Gehäusewand für Geräte des persönlichen Bedarfs, wie Elektrorasierer, Filmkameras, elektrische Zahnbürsten oder dergleichen eingesetzt. Beispielsweise in der DE-A 27 39 137 ist bereits eine perforierte Gehäusewand beschrieben, bei der eine Folie auf die Innenfläche der Gehäusewand z. B. aufgeklebt ist, wobei diese Folie oder Platte aus einem Kunststoff oder anderem gummiähnlichen Werkstoff, z. B. Elastomer, besteht. Die Folie ist einseitig mit einer Vielzahl von über eine Fläche der Folie oder der Platte vorstehenden Noppen oder zungenartigen Vorsprüngen versehen, die nach Laage, Zahl und Größe so angeordnet sind, daß sie sich durch die Perforationen der Gehäusewand hindurch erstrekken und um ein Geringes über die Außenfläche des Gehäuses hervorstehen. Dabei ist die perforierte Gehäusewand ein Kunststoff-Spritzgußteil, bestehend aus einem Kunststoff mit anderen Eigenschaften als der Kunststoff der Folie oder Platte. Obwohl sich derartige Gehäuse im praktischen Gebrauch weitgehend durchgesetzt haben, sind Herstellungsaufwand und Fertigungskosten derartiger Gehäuse, die bevorzugt in Massenproduktion hergestellt werden, sehr hoch. Auch sind die für die Herstellung derartiger Gehäuse erforderlichen Spritzgußwerkzeuge aufwendig und kostspielig.

Der Erfindung liegt demgegenüber die Aufgabe zugrunde, eine Wand mit den eingangs genannten Merkmalen dahingehend weiterzubilden, daß diese Wand bei hoher Gestaltungsfreiheit unter geringem Kostenaufwand herstellbar ist.

Diese Aufgabe wird erfindungsgemäß im wesentlichen dadurch gelöst, daß in den Bereichen jeweils wenigstens eine, den ersten Kunststoff durchsetzende Durchbrechung der Wand vorhanden ist und Verbindungsbereiche auf der Innenfläche der Wand zwischen den Durchbrechungen mit dem zweiten Kunststoff versehen sind, wobei der zweite Kunststoff in den Bereichen und Verbindungsbereichen einstückig verbunden, d. h. einstückig zusammenhängend ist.

Durch diese Maßnahmen ist es möglich, alle Bereiche der aus dem ersten Kunststoff bestehenden Wand durch Anspritzen über einen einzigen Anspritzpunkt mit dem zweiten Kunststoff zu versehen. Der einzige Anspritzpunkt für sämtliche Bereiche ist praktisch frei positionierbar und kann dementsprechend durch eine besondere Anordnung weitgehend kaschiert werden. Von diesem Anspritzpunkt in einem der Bereiche fließt der Kunststoff über die Durchbrechungen und Verbindungsbereiche an der Innenfläche der Wand zu den anderen Bereichen durch die jeweils dort vorgesehene Durchbrechung. Auch das hierfür erforderliche Spritzgußwerkzeug ist recht unaufwendig herstellbar, da der Anspritzpunkt auf der Außenfläche der Wand vorgesehen ist. Komplizierte Ausbildungen, bei denen der Anspritzpunkt beispielsweise im Kern des Spritzgußwerkzeuges vorgesehen ist, werden somit vermieden.

Des weiteren können die Verbindungsbereiche auf der Innenfläche der Wand zwischen den Durchbrechungen, die mit dem zweiten Kunststoff versehen sind, weitgehend frei gestaltet werden und verschiedene technische Funktionen übernehmen. So können diese Verbindungsbereiche der Schalldämmung dienen oder aber auch als Lichtschirm wirken, wodurch verhindert wird, daß in dem Gehäuse vorgesehene Signallampen neben dem Sichtfenster durch das Gehäuse scheinen. Auch können diese Zwischenbereiche als Federelement zum elastischen Abstützen von Einbauteilen innerhalb des Gehäuses dienen. Hierdurch wird die Stoßfestigkeit des Gerätes erhöht, ein Ausgleich von Toleranzen und Wärmedehnungen ermöglicht und die Übertragung von Vibrationen vermindert. Die einzelnen Bereiche auf der Außenfläche, die mit dem zweiten Kunststoff versehen sind, sind über die Durchbrechungen und die auf der Innenfläche vorhandenen Verbindungsbereiche, die ebenfalls mit dem zweiten Kunststoff versehen sind, untereinander verbunden, so daß die Bereiche und Verbindungsbereiche mittels eines einzigen Anspritzvorganges und über einen einzigen Anspritzpunkt mit dem zweiten Kunststoff versehen werden können.

Nach einer vorteilhaften Ausführungsform der Erfindung ist der erste Bereich der Wand hinsichtlich der Form identisch mit der zugehörigen Durchbrechung und vollständig durch den zweiten Kunststoff gebildet. Der zweite Kunststoff, der im ausgehärteten Zustand vorzugsweise elastisch ist, dient somit als Membran, welche die Wand in diesem ersten Bereich bildet, wobei hinter der Membran beispielsweise ein Schalter angeordnet sein kann. Im inneren Bereich kann die Membran dünner als die normale, feste Wand des Gehäuses ausgebildet sein, wodurch ihre Flexibilität erhöht wird.

Dadurch, daß der zweite Bereich der Wand, die aus dem ersten Kunststoff besteht, durch eine Vertiefung, z. B. eine Nut, Sicke oder dergleichen, auf der Außenfläche definiert und in die Vertiefung der zweite Kunststoff eingebracht ist, können außenliegende Griffleisten auf der Wand angeordnet werden, durch die beispielsweise die Griffigkeit des Gehäuses verbessert werden kann. Hierzu wird ein zweiter Kunststoff eingesetzt, der bevorzugt einen höheren Reibwert und eine geringere Härte als der erste Kunststoff aufweist. Weist der zweite Kunststoff eine andere Farbe als der erste Kunststoff auf, so können Bereiche ästhetischer oder informativer Funktion geschaffen werden, beispielsweise Bereiche mit Symbolen, Handhabungsanweisungen oder Bereiche mit anderem Design.

Nach einer anderen Ausgestaltung der Erfindung ist im zweiten Bereich der Wand der zweite Kunststoff auf der Außenfläche als Verdickung angebracht. Derartige Bereiche können als Auflagepunkte zum Ablegen des Gerätes des persönlichen Bedarfs dienen. Sofern der zweite Kunststoff weich ist, kann ein geräuschloses und schonendes Ablegen des Gerätes gewährleistet werden. Hat der zweite Kunststoff beispielsweise einen hohen Reibwert, so ist das Gerät gegen Verschieben und Abrutschen auf bzw. von der Unterlage gesichert.

Von Vorteil sind die Verbindungsbereiche auf der Innenfläche der Wand als die Innenfläche wenigstens teilweise bedeckende Schicht ausgebildet. Der speziellen Formgebung der Verbindungsbereiche sind kaum Grenzen gesetzt. Diese Formgebung kann an die speziellen Erfordernisse angepaßt werden. Wird als zweiter Kunststoff ein nur wenig lichtdurchlässiger Kunststoff eingesetzt, so können an der Innenfläche der Wand liegende Verbindungsbereiche, die mit diesem zweiten Kunststoff bedeckt sind, als Lichtschirm wirken und verhindern, daß beispielsweise in dem Gerät eingesetzte Signallampen neben dem Sichtfenster durch das Gehäuse scheinen. Auch können diese Verbindungsbereiche, die mit dem zweiten Kunststoff bedeckt sind, zur Schalldämmung dienen und Geräusche, beispielsweise eines Motors oder Getriebes, abschwächen, so daß diese gedämpft nach außen dringen. Auch kann die Dicke der die Innenfläche bedeckenden Schicht des zweiten Kunststoffs variabel sein, so daß beim Einsatz eines elastischen, zweiten Kunststoffs die Verbindungsbereiche beispielsweise als Federlement zum elastischen Abstützen von Einbauteilen dienen. Auch können diese Verbindungsbereiche zum Ausgleich von Toleranzen und Wärmedehnungen je nach Einsatzzweck speziell gestaltet werden.

Gemäß einer vorteilhaften weiteren Ausgestaltung der Erfindung ist in einem Bereich der Außenfläche eine warzenähnliche Erhöhung oder Verdikkung des zweiten Kunststoffs vorhanden. Bevorzugt ist diese Verdickung auf der Membran angeordnet und dient zur taktilen und optischen Markierung beispielsweise einer Ein- und Ausschalttaste eines hinter der Membran angeordneten Schalters. Auf dieser Verdickung wird vorzugsweise der einzige Anspritzpunkt für den zweiten Kunststoff vorgesehen, so daß der Anspritzpunkt weitgehend kaschiert ist. Natürlich kann der einzige Anspritzpunkt für den zweiten Kunststoff auch an optisch weniger exponierten Bereichen des Geräten angeordnet werden.

Nach einer anderen Ausführungsform der Erfindung ist der zweite Kunststoff in einem Bereich als eine aus der Außenfläche heraustretende Erhöhung ausgebildet. Derartige Bereiche können als Auflagepunkte zum Ablegen des Gerätes dienen und gestatten ein geräuschloses und schonendes Ablegen, sofern ein elastischer bzw. weicher zweiter Kunststoff eingesetzt wird.

Von Vorteil sind der erste und zweite Kunststoff durch Verschmelzen, Versintern, Diffundieren oder dergleichen miteinander verbunden. Handelt es sich bei den beiden Kunststoffen um Polypropylen, so gehen beide Kunststoffe eine unlösbare Verbindung ein. Hierdurch besteht die Möglichkeit, ein wasserdichtes Gehäuse zu schaffen, welches dennoch die Betätigung eines im Gehäuseinneren angeordneten Schalters über beispielsweise eine flexible Membran zuläßt. Solche Gehäuse werden von Vorteil bei elektrischen Zahnbürsten, Mundduschen, Haushaltsmaschinen oder auch Rasierapparaten eingesetzt.

Weitere Merkmale, Vorteile und Anwendungsmöglichkeiten der Erfindung ergeben sich aus der nachfolgenden Beschreibung der Ausführungsbeispiele, die in der Zeichnung näher dargestellt sind. Dabei bilden alle beschriebenen und/oder bildlich dargestellten Merkmale für sich oder in beliebiger Kombination den Gegenstand der Erfindung, unabhängig von ihrer Zusammenfassung in den Ansprüchen und deren Rückbeziehung.

Es zeigen:

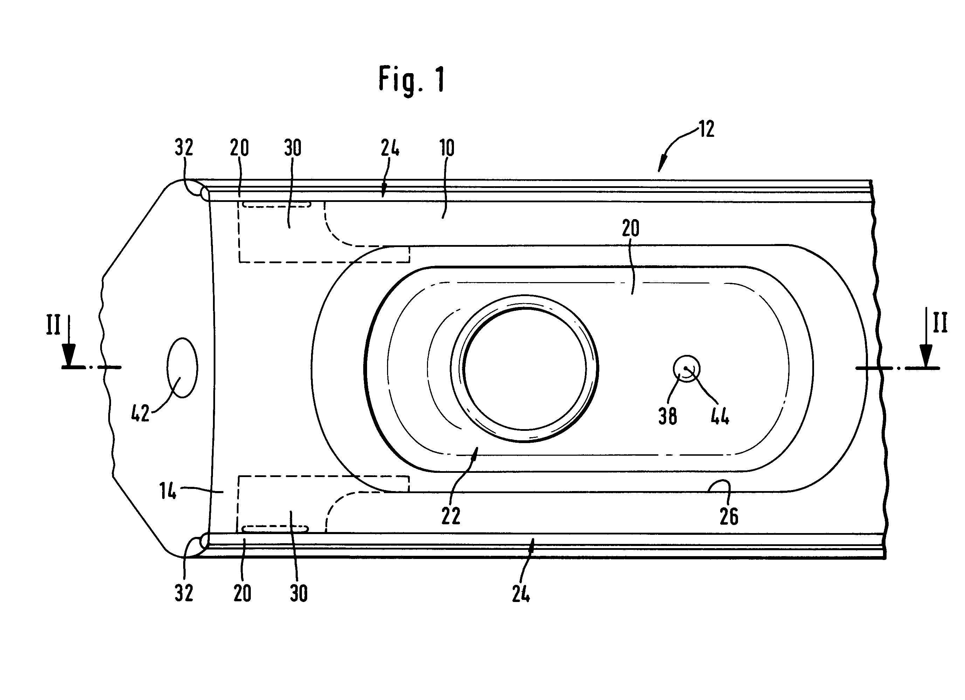

Fig. 1 eine Seitenansicht eines Gehäuses mit einer Wand nach der Erfindung,

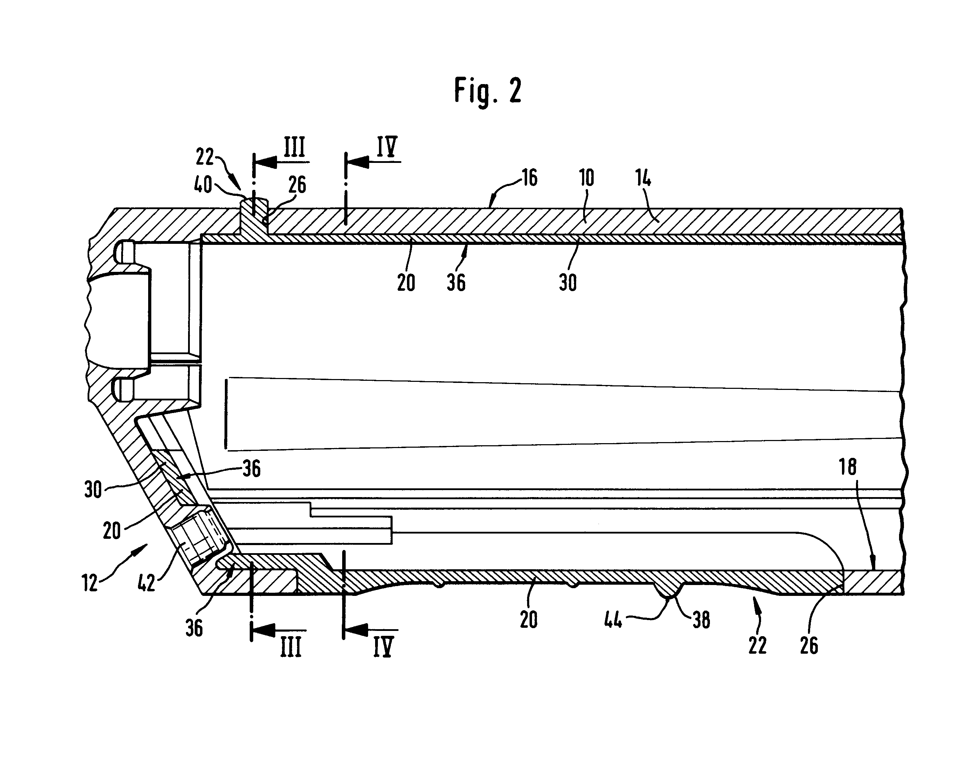

Fig. 2 einen Längsschnitt 11-11 durch das Gehäuse der Fig. 1,

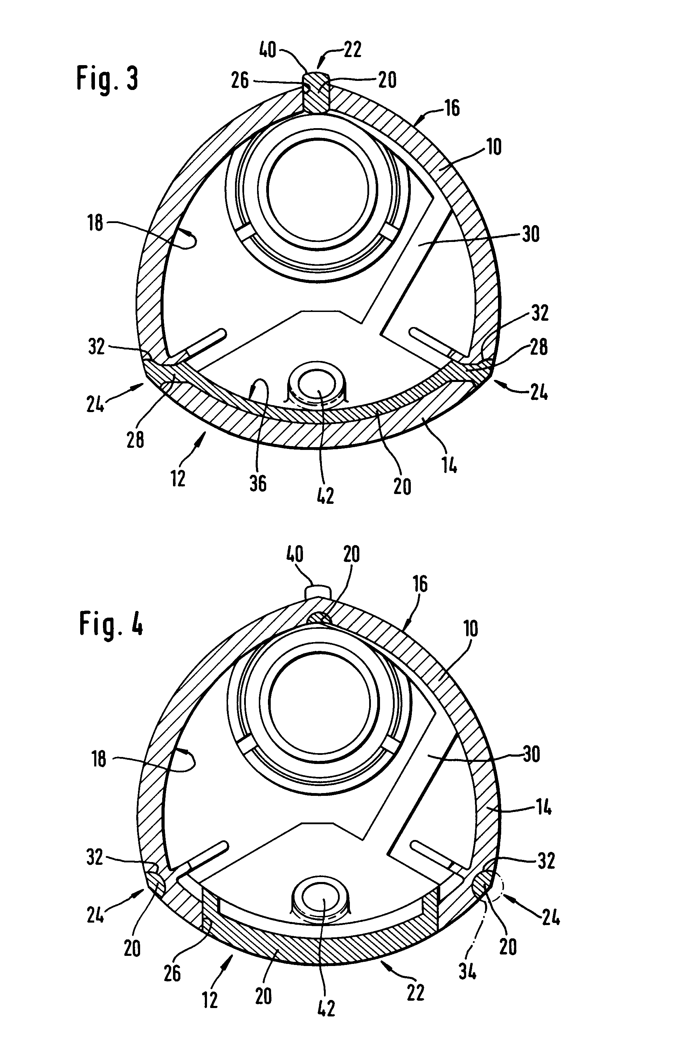

Fig. 3 einen Querschnitt 111-111 durch das Gehäuse der Fig. 2 und
Fig. 4 einen Querschnitt IV-IV durch das Gehäuse der Fig. 2.

In den Figuren ist im Ausführungsbeispiel ein Gehäuse 12 eines Geräts des persönlichen Bedarfs, und zwar eine elektrische Zahnbürste, dargestellt. Das Gehäuse 12 weist eine Wand 10 mit einer Außenfläche 16 und einer Innenfläche 18 auf.

Die Wand 10 besteht aus einem ersten, bevorzugt festen Kunststoff 14. Bereiche 22, 24, 25 sind mit einem zweiten Kunststoff 20 versehen, der andere Eigenschaften, z. B. eine andere Farbe, Härte oder einen anderen Reibwert aufweist als der erste Kunststoff 14. In diesen Bereichen 22, 24, 25 ist jeweils wenigstens eine den ersten Kunststoff 14 durchsetzende Durchbrechung 26, 28, 29 der Wand 10 vorhanden. Verbindungsbereiche 30 auf der Innenfläche 18 der Wand 10 zwischen den Durchbrechungen 26, 28,29 sind mit dem zweiten Kunststoff 20 bedeckt. Dabei sind die Bereiche 22, 24, 25 sowie die Verbindungsbereiche 30, die alle den zweiten Kunststoff 20 aufweisen, über die Durchbrechungen 26, 28, 29 einstückig miteinander verbunden.

Der erste Bereich 22 der Wand 10 ist in der Form identisch mit der zugehörigen Durchbrechung 26 und wird vollständig durch den zweiten Kunststoff 20 gebildet. Dieser erste Bereich 22 bildet, sofern ein elastischer zweiter Kunststoff 20 eingesetzt wird, eine Membran, hinter der ein Schalter oder dergleichen angeordnet sein kann, der durch Drücken auf die Membran betätigbar ist. Der zweite Bereich 24 der Wand 10 ist durch eine Vertiefung 32, im Ausführungsbeispiel eine Längsnut, auf der Außenfläche 16 definiert. In die Längsnut ist der zweite Kunststoff 20 eingebracht. Der zweite Kunststoff 20 kann, wie beispielhaft in Fig. 4 dargestellt, in dem zweiten Bereich 25 der Wand 10 auf der Außenfläche 16 als Verdickung 34 aufgebracht werden.

Die Verbindungsbereiche 30 auf der Innenfläche 18 der Wand 10 sind als die Innenfläche 18 wenigstens teilweise bedeckende Schicht 36 ausgebildet. In dem Bereich 22 der Außenfläche 16 ist eine warzenähnliche Erhöhung oder Verdickung 38 des zweiten Kunststoffs 20 vorhanden, auf der der einzige Anspritzpunkt 44 für den zweiten Kunststoff 20 vorgesehen ist. In einem Bereich 22 ist der zweite Kunststoff 20 als eine aus der Außenfläche 16 heraustretende Erhöhung 40 ausgebildet.

Die Schicht 36 bzw. die Verbindungsbereiche 30 können als Federelement zum elastischen Abstützen von Einbauteilen oder aber auch als Schalldämmung dienen. Sofern als zweiter Kunststoff 20 ein nur wenig lichtdurchlässiger Kunststoff eingesetzt wird, können an der Innenfläche 18 vorhandene Schichten 36 als Lichtschirm wirken und verhindern, daß eine Signallampe 42 neben den darüber angeordneten Sichtfenstern seitlich durch das Gehäuse 12 scheint.

Der erste und zweite Kunststoff 14, 20 bilden durch Verschmelzen, Diffundieren oder Versintern eine unlösbare hermetische Verbindung, so daß ein dichtes Gehäuse geschaffen wird. Die Durchbrechungen 28 zur Verbindung der Längsnuten mit den Verbindungsbereichen 30 sind bevorzugt als den ersten Kunststoff durchsetzende Löcher mit einem Durchmesser von etwa 0,5 bis 2 mm ausgebildet, können entsprechend den Bedürfnissen aber auch anders gestaltet werden.

## Patentansprüche

1. Wand (10), insbesondere Gehäusewand eines Gehäuses (12) für ein Gerät des persönlichen Bedarfs, wie Zahnbürste, Munddusche, Rasierapparat, Küchengerät oder -maschine und dergleichen, bestehend aus einem ersten Kunststoff (14) oder dergleichen, mit einer Außenfläche (16) und einer Innenfläche (18) und mit wenigstens zwei mit einem zweiten Kunststoff (20) anderer Eigenschaften, z. B. Farbe, Härte Reibwert oder dergleichen, versehenen Bereichen (22, 24) der Außenfläche (16) der Wand (10), dadurch gekennzeichnet, daß in diesen Bereichen (22, 24) jeweils wenigstens eine, den ersten Kunststoff (14) durchsetzende Durchbrechung (26, 28) der Wand (10) vorhanden ist und Verbindungsbereiche (30) der Innenfläche (18) der Wand (10) zwischen den Durchbrechungen (26, 28) mit dem zweiten Kunststoff (20) versehen sind, wobei der zweite Kunststoff (20) in den Bereichen (22, 24) und Verbindungsbereichen (30) einstückig verbunden ist.

2. Wand nach Anspruch 1, dadurch gekennzeichnet, daß der erste Bereich (22) der Wand (10) hinsichtlich der Form identisch mit der zugehörigen Durchbrechung (26) und durch den zweiten Kunststoff (20) gebildet ist.

3. Wand nach einem der vorhergehenden Ansprüche, dadurch gekennzeichnet, daß der zweite Bereich (24) der Wand (10), bestehend aus dem ersten Kunststoff (14), durch Vertiefungen (32), z. B. eine Nut, Sicke oder dergleichen, auf der Außenfläche (16) definiert und in die Vertiefung (32) der zweite Kunststoff (20) eingebracht ist.

4. Wand nach einem der vorhergehenden Ansprüche, dadurch gekennzeichnet, daß in dem zweiten Bereich (24) der Wand (10) der zweite Kunststoff (20) auf der Außenfläche (16) als Verdickung (34) der Wand (10) aufgebracht ist.

5. Wand nach einem der vorhergehenden Ansprüche, dadurch gekennzeichnet, daß die Verbindungsbereiche (30) der Innenfläche (18) der Wand (10) als die Innenfläche (18) wenigstens teilweise bedeckende Schicht (36) ausgebildet sind.

6. Wand nach einem der vorhergehenden Ansprüche, dadurch gekennzeichnet, daß in einem der Bereiche (22, 24) der Außenfläche (16) eine warzenähnliche Erhöhung oder Verdickung (38) des zweiten Kunststoffs (20) vorhanden ist.

7. Wand nach einem der vorhergehenden Ansprüche, dadurch gekennzeichnet, daß der zweite Kunststoff (20) in einem Bereich (22, 24) als eine aus der Außenfläche (16) heraustretende Erhöhung (40) ausgebildet ist.

8. Wand nach einem der vorhergehenden Ansprüche, dadurch gekennzeichnet, daß der erste und zweite Kunststoff (14, 20) durch Verschmelzen, Versintern, Diffundieren oder dergleichen miteinander verbunden sind.
